## Europäisches Patentamt
## European Patent Office
## Office européen des brevets

(19)

(11) Numéro de publication : **0 008 661**
**B1**

(12)

# FASCICULE DE BREVET EUROPÉEN

(45) Date de publication du fascicule du brevet :
05.10.83

(21) Numéro de dépôt : **79102641.2**

(22) Date de dépôt : **25.07.79**

(51) Int. Cl.³ : **H 01 L 21/322, H 01 L 21/324, H 01 L 29/167, C 30 B 33/00**

(54) **Procédé de traitement thermique préliminaire de corps semiconducteurs pour en accroître ultérieurement l'effet de piégeage interne.**

(30) Priorité : 08.09.78 FR 7826223

(43) Date de publication de la demande :
19.03.80 Bulletin 80/06

(45) Mention de la délivrance du brevet :
05.10.83 Bulletin 83/40

(84) Etats contractants désignés :
DE FR GB

(56) Documents cités :
FR A 2 204 046
FR A 2 280 976

JOURNAL OF APPLIED PHYSICS, vol. 49, no 5, mai 1978, New York, C. PLOUGONUEN et al. « Ring-shaped stacking faults induced by oxide precipitates in silicon », pages 2711-2716

IBM T.D.B., vol. 20, no 2, juillet 1977, New York, S.M. HU : « Optimum preprocessing heat treatment for lifetime improvement », pages 587

JOURNAL OF APPLIED PHYSICS, vol. 47, no 9, septembre 1976, New York, D.M. MAHER et al. « Characterization of structural defects in annealed silicon containing oxygen », pages 3813-3825.

IBM Technical Disclosure Bulletin, vol. 19, no 12, mai 1977, pages 4618 et 4619 (S.M. Hu et al.)

SAP, vol. 46, no 5, mai 1975, pages 1869 à 1874 (S.M. Hu et al.)

(73) Titulaire : International Business Machines Corporation
Old Orchard Road
Armonk, N.Y. 10504 (US)
DE GB
Compagnie IBM FRANCE
5 Place Vendôme
F-75000 Paris 1er (FR)
FR

(72) Inventeur : Cazcarra, Victor Gaston
51 avenue de Neufville
F-91540 Mennecy (FR)

(74) Mandataire : Klein, Daniel
COMPAGNIE IBM FRANCE Département de Propriété Industrielle
F-06610 La Gaude (FR)

Procédé de traitement thermique préliminaire de corps semi-conducteurs pour en accroître
ultérieurement l'effet de piégeage interne

Description

Domaine technique

La présente invention concerne un procédé de traitement thermique préliminaire de corps semiconducteurs pour en accroître ultérieurement l'effet de piégeage interne. Elle concerne plus particulièrement la génération de petits amas ou germes pour la formation ultérieure de précipités d'atomes d'oxygène destinés à être utilisés, comme centres de piégeage d'impuretés non désirées, au cours des différents cycles thermiques auxquels sont habituellement soumis ces corps dans la fabrication des circuits intégrés à semi-conducteurs. Elle concerne également les corps semi-conducteurs : barreaux monocristallins ou tranches, obtenues à l'aide du procédé de la présente invention.

Ces dernières années, les techniques des circuits intégrés à semi-conducteurs et plus particulièrement, la technologie et les dispositifs au silicium ont connu un développement considérable. Le but est maintenant d'atteindre des niveaux d'intégration jamais connus, c'est-à-dire d'atteindre une densité d'environ plusieurs milliers de circuits par millimètre carré sur une tranche semi-conductrice. Des problèmes aigus ont été détectés dans certaines étapes du procédé de fabrication, par exemple en photogravure, mais également au niveau du matériau lui-même, parce que son comportement et ses propriétés ne sont pas complètement maîtrisés.

C'est ainsi que le matériau semi-conducteur, typiquement du silicium, nécessite une meilleure connaissance du point de vue de la physique du solide. Plus particulièrement, la présence de défauts tels que les précipités, les migrations d'impuretés, en plus des défauts cristallographiques : tels les dislocations et les défauts d'empilement, ont une influence prédominante sur les rendements, les performances et la fiabilité des dispositifs semi-conducteurs. Ces défauts ou microdéfauts sont bien connus d'un point de vue théorique et la littérature qui s'y rapporte est abondante.

Ces défauts causent généralement dans la masse du matériau de silicium des conduits, qui provoquent des court-circuits entre l'émetteur et le collecteur, des claquages non désirés, des jonctions graduelles, des dopages non uniformes, ainsi que des modifications de la durée de vie des porteurs et de la résistivité du matériau. Ils provoquent en outre des modifications dans certains paramètres importants des dispositifs : les gains, les courants de fuite, les tensions de saturation, etc. avec encore des effets secondaires non désirés en ce qui concerne la dissipation de puissance et la génération du bruit notamment.

Le phénomène de conduit est bien connu dans l'art des dispositifs semi-conducteurs. Par exemple, des conduits dans les transistors NPN sont définis comme des régions de type N, de forme cylindrique, s'étendant de la région collecteur pour atteindre la région émetteur à travers la région de base de type P. Il a été montré que les défauts cristallographiques, qui comprennent les défauts d'empilement et les dislocations, agissent souvent comme des sites pour la formation de ces conduits ; des diffusions renforcées prennent souvent place le long de ces défauts et plus particulièrement le long des lignes de dislocation ce qui entraîne des court-circuits émetteur-collecteur défavorables à de bonnes performances des dispositifs. Plus généralement, les dislocations, qui consistent en une chaîne de discontinuités, peuvent être considérées comme un chemin préférentiel pour les migrations de charges sur de grandes distances à l'intérieur du matériau semi-conducteur.

Outre les court-circuits et le dopage non uniforme qui sont causés par les dislocations existantes, la présence de contaminants dans la masse du matériau a été également à l'origine de problèmes importants. Ces contaminants peuvent être des atomes d'impuretés semi-conductrices ou de métaux, ces derniers qui comprennent le fer, le nickel, le cuivre et l'or sont fréquemment présents dans le matériau semi-conducteur. Ils forment facilement des précipités métalliques ou agrégats dans ou au voisinage des jonctions PN et sont souvent des sources de défauts. Les dispositifs qui comportent de telles jonctions présentent alors un courant de fuite important, sont de mauvaise qualité et devront être ultérieurement rejetés. Ce phénomène est appelé « softness » dans la littérature anglo-saxonne. Il a été montré que les précipités nécessitent des centres de nucléation ; les dislocations fournissent ces centres tandis que les dopants qui précipitent le long de ces dislocations deviennent électriquement inactifs.

Tous ces aspects sont clairement décrits dans la publication de F. Barson, intitulée « Emitter Collector Shorts in Bipolar Devices » in Technical Digest 1975 International Electron Devices Meeting, décembre 1975, Washington D. C. USA.

Pendant longtemps, les défauts ou microdéfauts ont été soumis à de nombreuses études pour déterminer des procédés de fabrication qui les élimineraient et qui produiraient donc des dispositifs et des cristaux sans dislocations. Cependant des auteurs, comme A. H. Cottrell dans un livre intitulé « Dislocations and Plastic Flow in Crystals » (Oxford University Press 1953), ont montré qu'une faible densité de dislocations dans le matériau semi-conducteur pouvait être bénéfique pour la production de dispositifs de qualité. L'étude de A. H. Cottrell était basée sur l'effet de piégeage des dislocations, il a démontré que les dislocations pouvaient attirer certains défauts ponctuels, par exemple des impuretés et ainsi s'entourer d'une atmosphère d'impuretés non désirées, il a considéré les dislocations comme des puits internes pour ces défauts ponctuels et a conclu que les dislocations avaient la propriété de nettoyer la masse cristalline de ce genre de défauts.

C'est ainsi que maintenant, on considère de plus en plus que, dans les circuits intégrés à semi-conducteurs à forte densité d'intégration, le piégeage des impuretés devient une nécessité.

## Etat de la technique antérieure

L'introduction de centres de piégeage ou sites de nucléation dans des corps semi-conducteurs, par exemple en silicium est désormais bien connue dans l'art et s'effectue selon des techniques très variées. On peut d'abord de façon classique introduire des défauts par implantation ionique d'impuretés non dopantes généralement de l'argon ou du silicium, soit sur la face avant des tranches de silicium comme décrit dans les brevets des E.U.A N° 3 874 936 et 4 069 068 (IBM), soit sur la face arrière.

On peut utiliser également en surface une couche d'un verre dopé ou bore ou au phosphore pour piéger ces impuretés. Une autre technique a consisté à former une couche de silicium polycristalline sur l'arrière de la tranche (brevet des E.U.A N° 4 053 335).

On peut également introduire ces centres à partir d'un faisceau de radiation tel que celui d'un laser, ou encore en endommageant mécaniquement la tranche lors du rodage, par exemple brevet des E.U.A. N° 3 905 162.

Toutes ces techniques présentent de graves inconvénients, en particulier celles qui font appel à l'implantation ionique nécessitent généralement au moins une étape supplémentaire d'implantation toujours longue et coûteuse et souvent une étape de lithographie supplémentaire.

Aussi on peut alors se demander si des résultats équivalents ne pourraient être obtenus par l'intermédiaire d'un effet de piégeage interne, par la génération de petits amas qui serviraient de sites de nucléation où viendraient se localiser les impuretés, lors des cycles thermiques ultérieurs.

Ce concept de piégeage interne des impuretés non désirées se trouve présenté dans l'article de E. Biedermann intitulé « Producing Silicon Semi-conductor Wafers With a High Internal Getter Density and a Surface Layer Free From Lattices Defects » paru dans l'IBM Technical Disclosure Bulletin, Vol. 19, N° 4, septembre 1976, page 1295. Dans cet article, il est fait mention d'un recuit thermique de la tranche, effectué à haute température, qui fait diffuser les défauts vers l'intérieur de la tranche, ce qui permet d'obtenir une couche de surface sans défauts, où seront formés les dispositifs actifs et/ou passifs tout en gardant un effet utile de piégeage au centre de la tranche. Cet article reste donc très vague sur la nature précise des conditions opératoires.

Dans un article paru dans l'IBM Technical Disclosure Bulletin, Vol. 19, N° 12, mai 1977, pages 4618-4619 intitulé « Gettering by Oxygen Precipitation », les auteurs S. M. Hu, J. Patrick et W. A. Westdorp, font ressortir le rôle que les précipités d'oxygène peuvent jouer comme centres de piégeage des impuretés avec comme conséquence, une amélioration importante des propriétés électriques des dispositifs, cependant ils ne s'attachent qu'au niveau initial d'oxygène qu'ils jugent optimum. Cette étude ne tient compte que de la diffusion de l'oxygène de la surface vers le centre de la tranche mais ignore le fait que les tranches peuvent contenir plus ou moins de centres de précipitation. Ils recommandent, pour augmenter le nombre de précipités, de procéder à un recuit thermique à 1 000 °C pendant un temps supérieur à 4 heures. Les recommandations qu'ils font aux fabricants tant de produits bipolaires qu'unipolaires, portent donc sur une donnée certes importante : le niveau initial d'oxygène, mais très incomplète, car ils ne fournissent aucun élément sur son comportement.

En d'autres termes, il s'agit uniquement d'un traitement de précipitation, c'est-à-dire le grossissement des germes par diffusion, qui ne peut être d'ailleurs appliqué qu'aux seules tranches et non aux barreaux. Il suppose la préexistence de germes. Le problème de la germination c'est-à-dire, la création de centres de nucléation n'est pas évoqué. La température choisie : 1 000 °C est trop élevée pour permettre la germination.

L'application du procédé décrit dans la publication ci-dessus à des barreaux, permettrait effectivement la précipitation de l'oxygène mais en raison de la taille des précipités, serait catastrophique pour la qualité cristalline du barreau.

Le procédé de la présente invention qui consiste dans un recuit thermique (1-8 heures, 750°-900 °C) assure la germination désirée de très petits germes et peut être appliqué non seulement aux tranches, mais également aux barreaux car les germes ainsi créés sont également répartis dans la masse et ne causent pas de perturbations cristallines.

La précipitation s'effectuant ultérieurement lors des étapes thermiques classiques (oxydation, épitaxie, ...) du traitement ultérieur des tranches.

Dans un article paru dans l'IBM Technical Disclosure Bulletin, Vol. 20, N° 2, juillet 1977, page 587, intitulé : « Optimum Preprocessing Heat Treatment for Lifetime Improvement » l'auteur S. M. Hu décrit un procédé en trois étapes : un pré-traitement thermique des tranches de 2 à 8 heures à une température comprise entre 950 et 1 050 °C, un refroidissement à température ambiante, puis un nouveau traitement thermique à la même température mais pendant un temps compris entre 8 et 72 heures.

Cet article apparaît très voisin du précédent. Le traitement ne se rapporte qu'à des tranches exclusivement et son application à des barreaux serait, pour les mêmes raisons que celles mentionnées ci-dessus, catastrophique. Pour les mêmes raisons également la génération de germes est très faible en raison de la gamme de températures choisie (950-1 050 °C), 900 °C apparaissant la limite supérieure du traitement thermique qui assure une germination suffisante, comme cela sera montré ci-après dans la description. La première étape éthermique ne crée donc pas de germes mais fait grossir ceux existants, l'étape thermique suivante (outre qu'elle est très longue, 8-72 heures, et donc peu intéressante sur le plan industriel) assure une précipitation totale de l'oxygène sur les germes (avec les inconvénients mentionnés ci-dessus). Le procédé de recuit de la présente invention (750-900° ; 1-8 heures), qui comporte une seule étape et assure une germination efficace, ne peut pas non plus être comparé au procédé décrit dans cette publication de S. M. Hu.

D'autres auteurs, D. M. Maher, A. Standinger et J. R. Patel dans un article intitulé « Characterization of Structural Defects in Annealed Silicon Containing Oxygen » paru dans le Journal of Applied Physics, Vol. 47, N° 9, septembre 1976, pages 3813 à 3825, ont mis en évidence le rôle joué par l'oxygène dans la formation de défauts, précipités, dislocations, ... L'étude a été réalisée à partir d'un barreau tiré selon la méthode de Czochralski soumis à un premier recuit : 700 °C pendant 2 heures, et, scié en tranches. Les tranches ont été soumises à un deuxième recuit à 1 000 °C pendant 45 heures et ensuite caractérisées à l'aide d'un microscope électronique à transmission pour déterminer la nature des défauts présents dans la tranche. Ces auteurs ont précisé que le premier recuit à 700 °C pendant deux heures assurait la génération de petits amas agissant comme sites de nucléation nécessaires à la formation de précipités au bénéfice du deuxième recuit. Ce deuxième recuit est d'ailleurs très important : 45 heures à 1 000 °C. Il n'est nulle part précisé que les sites de nucléation sont utiles pour assurer l'effet de piégeage interne dans les cycles thermiques ultérieurs, qui est précisément l'objet de la présente invention, d'autant plus que ce premier recuit à 700 °C et pendant 2 heures, n'assure en fait qu'une très faible génération de petits amas de sorte que l'effet de piégeage serait très faible, sinon nul.

Ce recuit à 700° s'apparente tout à fait au recuit de stabilisation des barreaux bien connu qui s'effectue habituellement à 650 °C, pour stabiliser la résistivité du matériau semi-conducteur, c'est-à-dire pratiquement détruire les donneurs générés à 450 °C. C'est précisément parce que la génération de germes de petits amas est très faible, que l'obtention des précipités nécessite un deuxième recuit très long (45 heures) et à température élevée (1 000 °C), impraticable sur le plan industriel.

S. M. Hu et W. J. Patrick, dans un article paru dans le J.A.P. Vol. 46, N° 5 de mai 1975, page 1869 et intitulé « Effect of Oxygen on Dislocation Movement in Silicon », ont mis en évidence le rôle de l'oxygène dans la propagation des dislocations. La formation de petits amas (clusters) à des températures comprises entre 700 et 900 °C pour des concentrations d'oxygène supérieures ou égales à $1.10^{18}$ atomes/cm$^3$ a été seulement perçue. En particulier ils n'ont pas cherché à voir l'influence d'un bref traitement thermique dans le domaine 750-950 °C sur les étapes de traitement ultérieures à haute température. Les tranches de silicium obtenues à partir de barreaux tirés selon la méthode de Czochralski dans un four à résistance chauffante présentent généralement une concentration d'oxygène comprise entre 0,5 et $2.10^{18}$ atomes/cm$^3$. Cependant, d'une part, les traitements thermiques qu'ils suggèrent pour la génération de ces amas sont sans intérêt d'un point de vue industriel en raison de leur durée : 240 heures à 700 °C ou 96 heures à 900 °C, et d'autre part ils n'ont pas vu l'intérêt que pouvait présenter la présence de ces petits amas comme centres potentiels de piégeage lors des traitements thermiques ultérieurs à haute température.

Par ailleurs dans la gamme des températures citées (750-900°) la durée de recuit est comprise entre environ 100 et 240 heures, il est clair que s'il y a eu génération de germes, durant les premières heures de recuit, ces germes ont fait précipiter tout l'oxygène en raison de la longueur même du traitement. Pour les mêmes raisons que celles exposées déjà ci-dessus, ce procédé ne peut donc être utilisé qu'avec des tranches et non avec des barreaux. Quand les tranches traitées par le procédé arrivent dans les lignes de fabrication, elles n'ont plus de germes qui assureront après grossissement l'effet de piégeage désiré, mais par contre comportent ces précipités pré-existants qui peuvent être la cause de dislocations non désirées. En fait cet article s'intéresse uniquement au mouvement des dislocations.

Un article articulé : « Ring Shaped Stacking Faults Induced by Oxide Precipitates in Silicon », par C. Plougonven et al, publié au J.A.P. 49(5), mai 1978, page 2711 se rapporte à la croissance des défauts d'empilement en volume dans une gamme de températures comprises entre 950 et 1 200 °C avec des précipités d'oxygène servant de centre de nucléation pour ces défauts. L'aspect relatif à la génération de ces précipités n'est pas pris en compte. Le domaine de températures qui assure la génération des germes (750-900 °C) n'est pas utilisé. Il n'y a pas d'effet de génération de germes, on utilise ceux qui existent.

Ainsi aucun des arts antérieurs cités ci-dessus ne met en évidence la nécessité d'avoir dès le départ des petits amas en nombre suffisant autour desquels des atomes d'oxygène viendront ultérieurement précipiter. Cette précipitation s'effectuera au cours des différents cycles thermiques à haute température (entre 1 000 et 1 150 °C) du traitement habituel des tranches semi-conductrices pendant lesquelles ils assureront l'effet de piégeage indispensable. Ils n'ont pas plus démontré que de nouveaux petits amas sont efficacement générés lors d'un traitement thermique unique, effectué soit au niveau du barreau soit au niveau de la tranche, dans une gamme de température comprise entre 750 et 900 °C pendant une durée comprise entre 1 et 8 heures. En fait comme on le verra ci-après la courbe de génération des germes présente un pic pour 825 °C et l'effet de génération décroît très rapidement de part et d'autre de cette température. C'est pourquoi à cette température un court recuit de deux heures est suffisant. La

mise en œuvre d'un tel cycle thermique, en début du traitement de la tranche ne présente aucune difficulté du point de vue industriel.

En d'autres termes la présente invention qui concerne un recuit effectué de préférence sur le barreau permet de livrer aux lignes de fabrication des tranches « précipitables » c'est-à-dire qui contiennent de nombreux germes qui précipiteront l'oxygène ultérieurement à l'occasion des étapes normales de traitement des tranches. Alors que les procédés décrits ci-dessus conduisent pour la plupart à des tranches « précipitées », qui ne pourront précipiter davantage que si de longs traitements thermiques spéciaux qui n'ont pas normalement lieu d'exister sur les lignes de fabrication, leur sont appliqués.

Les tranches « précipitables » présentent les avantages suivants sur les tranches « précipitées » : moins de défauts cristallins, donc moins fragiles, capacité de piégeage interne ; il semble en effet que le piégeage soit un phénomène dynamique : c'est le déplacement des atomes d'oxygène lors de la précipitation qui assure le piégeage des impuretés.

## Exposé de l'invention

En résumé, au vu de l'état de l'art connu à ce jour du déposant, on connaît le rôle joué par des précipités oxygène pour assurer l'effet de piégeage interne des impuretés, mais pour les créer on a recours à des procédés thermiques à haute température et relativement longs.

Par ailleurs, l'art antérieur ne fournit aucune information relative à la quantité de précipités oxygène existant dans un matériau en silicium et à leur comportement au cours des cycles thermiques ultérieurs à haute température.

La présente invention propose un procédé de traitement thermique préliminaire de corps semi-conducteurs pour en accroître ultérieurement l'effet de piégeage interne en augmentant le nombre de précipités d'atomes d'oxygène. Ce procédé est caractérisé en ce que le corps semi-conducteur est soumis à une étape de recuit thermique à une température comprise entre 750 et 900 °C et d'une durée comprise entre 1 et 8 heures, de manière à générer des petits amas qui, bien qu'indétectables car trop petits, agiront ultérieurement comme sites de nucléation pour ces précipités.

En conséquence un objet de la présente invention est donc de fournir un procédé basse température susceptible de créer de petits amas autour desquels les atomes d'oxygène viendront précipiter au cours des cycles thermiques ultérieurs effectués à haute température, pour assurer un effet de piégeage interne.

D'autres objets, caractéristiques et avantages de la présente invention ressortiront mieux de l'exposé qui suit, fait en référence aux dessins annexés à ce texte, qui représentent un mode de réalisation préféré de celle-ci.

## Brève description des figures

La figure 1 montre un graphique qui représente les variations de la concentration d'oxygène pour deux tranches de silicium d'un premier barreau A, en fonction de la durée du recuit à 1 050 °C.

La figure 2 montre un graphique qui représente les variations de la concentration d'oxygène pour deux tranches de silicium d'un second barreau B, en fonction de la durée du recuit à 1 050 °C.

La figure 3 montre un graphique qui représente les variations du coefficient de précipitation $K_{1050}$ en fonction de la concentration initiale d'oxygène.

La figure 4 montre un graphique qui représente les variations du coefficient de précipitation $K_{1000}$ en fonction de la concentration initiale d'oxygène.

La figure 5 montre un graphique qui représente les variations du coefficient de précipitation $K_{1100}$ en fonction de la concentration initiale d'oxygène.

La figure 6 montre le graphique des variations du coefficient de précipitation $K_{1050}$ en fonction de la concentration initiale d'oxygène après des recuits initiaux à 650 °C de durées différentes.

La figure 7 montre le graphique des variations du coefficient de précipitation $K_{1050}$ en fonction de la concentration initiale d'oxygène après des recuits initiaux à 825 °C de durées différentes.

## Description du mode de réalisation préféré

Les investigations relatives à la nature et au niveau des impuretés dans les corps semi-conducteurs généralement utilisés dans l'industrie de la micro-électronique montrent, que dans le cas de barreaux de silicium tirés selon la méthode de Czochralski dans un four à résistance chauffante, on obtient les concentrations suivantes données en $10^{17}$ atomes/cm³ de silicium.

(Voir Tableau I, page 6)

Tableau I

| Oxygène | Carbone | Azote | Impuretés dopantes de 1 à 100 ohms de résistivité | Impuretés métalliques |
|---------|---------|-------|------------------------------------------------|----------------------|
| 2-20 | 0,3-4 | <0,005 | 0,001-0,13 | <0,005 |

La gamme $2\text{-}20 \times 10^{17}$ atomes d'oxygène/cm³ de silicium correspond à la gamme de 4-40 ppmA ; pratiquement les tranches de silicium utilisées présentent une concentration d'oxygène comprise entre 25 et 35 ppmA, 30 ppmA constituant une bonne approximation de la valeur moyenne. Comme cela apparaît clairement sur le tableau I l'oxygène est l'impureté la plus importante dans ce type de matériau.

Pour déterminer la concentration et l'évolution des précipités d'oxygène dans des tranches de silicium au cours des différents cycles thermiques (900°-1 200 °C) une étude expérimentale et un procédé de caractérisation seront ci-après décrits.

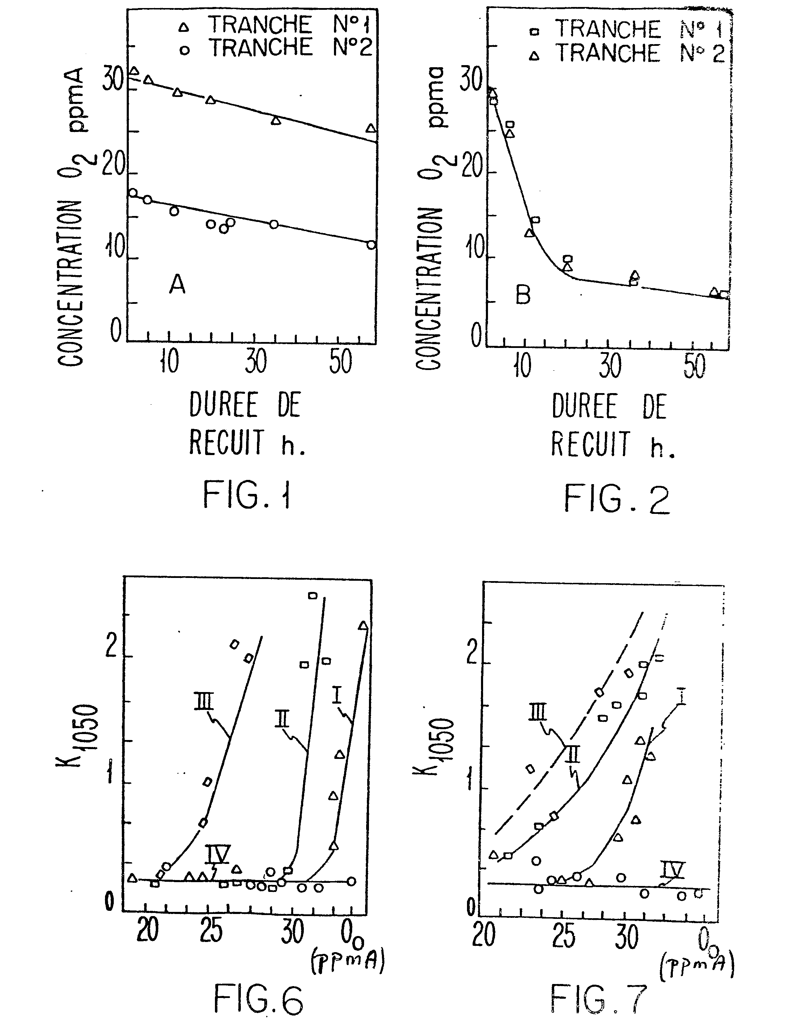

Des tranches de silicium de 400 microns d'épaisseur et parfaitement polies sur les deux faces et provenant de deux barreaux différents A et B ont été soumises à un recuit thermique à 1 050 °C. La concentration en oxygène en fonction de la durée du recuit a été mesurée selon les techniques d'absorption en infrarouge avec un Beckmann JB 4240. En effet les techniques infrarouges présentent de nombreux avantages : elles sont non destructives, bon marché, commodes d'emploi et relativement précises. Les résultats sont montrés sur les figures 1 et 2. L'expérimentation a montré que la précipitation d'oxygène variait considérablement d'un cristal à un autre mais que pour différentes tranches d'un même cristal, le comportement était sinon identique (figure 2) du moins similaire (figure 1). Les courbes représentées sur les figures 1 et 2 montrent qu'en chauffant à 1 050 °C, les petits amas se comportent comme des centres de piégeage et recueillent les atomes d'oxygène qui sont précipités autour d'eux, ce qui explique la décroissance très rapide de la concentration d'oxygène bien visible sur les courbes.

On peut donc admettre d'après ces résultats que la cinétique de la précipitation peut s'écrire :

$$d(O)/dt = -kN_c((O) - (O_f))$$

où (O) est la concentration en oxygène inversticiel près un recuit de t heures, $(O_f)$ la limite de solubilité de l'oxygène, $(O_0)$ la concentration initiale de l'oxygène et $N_c$ le nombre de petits amas stables.

On admet également que $(O_f)$ se trouve dans la gamme 0,5-3 ppmA et peut donc être négligé dès que l'on travaille avec des concentrations d'oxygène supérieures à 15 ppmA. Si on admet que le nombre de petits amas est proportionnel à la concentration d'oxygène initiale c'est-à-dire :

$$N_c = k_c(O_0)$$

On peut alors écrire :

$$d(O)/dt = -kk_c(O_0)(O) \text{ et avec } K_{1050} = kk_c$$

$$d(O)/dt = -K_{1050}(O_0)(O)$$

$$d(O)/(O) = -K_{1050}(O_0)dt$$

qui devient après intégration

$$Log(O) = -K_{1050}(O_0) t + \text{constante}$$

La condition aux limites est $(O) = (O_0)$ à $t = 0$ d'où

$$Log(O) = -K_{1050}(O_0) t + Log(O_0) \text{ et}$$

$$K_{1050} = -1/(O_0)t \, Log(O)/(O_0)$$

si nos hypothèses sont correctes ce coefficient devrait caractériser le phénomène de précipitation de l'oxygène à la température de 1 050 °C.

D'un point de vue pratique, la marche à suivre pour calculer ce coefficient peut être la suivante :
— mesure du niveau initial d'oxygène $(O_0)$ dans la tranche,

— recuit à 1 050 °C dans une atmosphère d'azote pendant t = 20 heures (meilleur temps recommandé d'après l'expérimentation pour éviter les erreurs),

— nettoyage de la tranche dans une solution d'acide fluorhydrique et,

— mesure du niveau d'oxygène (O).

Le résultat sera donné en $ppmA^{-1}h^{-1}10^{-3}$.

Sur la figure 3 on a représenté les valeurs de $K_{1050}$ pour des tranches ayant différentes valeurs de la concentration initiale d'oxygène $(O_0)$. Le coefficient $K_{1050}$ est constant, sauf pour des niveaux supérieurs à $(O_0) = 35$ ppmA, où alors le coefficient $K_{1050}$ augmente très rapidement. L'explication la plus plausible est que de nouveaux centres de précipitation ont été générés durant le traitement à 1 050 °C.

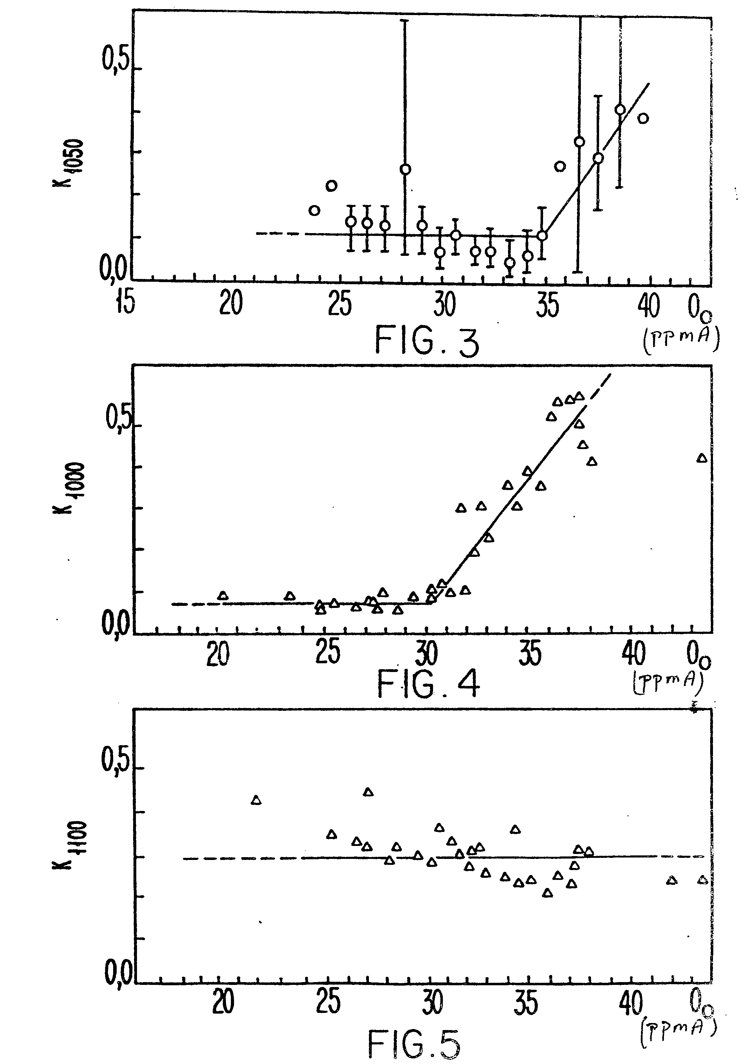

Sur les figures 4 et 5 on a respectivement montré les coefficients $K_{1000}$ et $K_{1100}$. Un recuit à 1 100 °C supprime ce phénomène de génération de centres de précipitation en effet $K_{1100}$ est approximativement constant. Toute cette expérimentation montre que les centres de précipitation sont plus facilement générés aux basses températures (dans une certaine gamme) et pour des niveaux d'oxygène plus élevés.

Ainsi en se basant sur un traitement thermique initial à une température inférieure à 1 000 °C et mieux encore inférieure à 900 °C, on peut penser que de nombreux centres de précipitation seraient créés au bénéfice des traitements thermiques ultérieurs effectués à haute température (diffusion, oxydation, etc.).

Des expérimentations ont donc été faites pour déterminer la nature de ce traitement (gamme de température — durée) pour obtenir l'optimisation de l'accroissement du taux de précipitation.

Pour cela des traitements thermiques à 650 °C et à 825 °C ont été effectués suivis dans tous les cas d'un traitement thermique à 1 050 °C pour déterminer le comportement du coefficient de précipitation $K_{1050}$.

Sur la figure 6 on a représenté les courbes (I, II, III) des variations du coefficient $K_{1050}$ en fonction de $(O_0)$ pour un barreau de silicium soumis à un recuit thermique à 650 °C pendant une durée de 8, 16, 32 heures respectivement. Sur la figure 7 on a représenté les courbes (I, II, III) des variations du coefficient $K_{1050}$ en fonction de $(O_0)$ pour un barreau de silicium soumis à un recuit thermique à 825 °C pendant une durée de 0,6, 2 et 7 heures respectivement. Dans les deux figures, la courbe IV représente la valeur du coefficient $K_{1050}$ en l'absence du traitement thermique. On s'aperçoit qu'un recuit de 2 heures à 825 °C (courbe II, figure 7) donne un $K_{1050} = 2$, soit un gain de l'ordre de 7 (voir courbe IV où $K_{1050} = 0,3$) pour une concentration initiale d'oxygène $(O_0) = 30$ ppmA.

D'autres expérimentations ont montré que les centres de précipitation étaient générés de manière efficace pour des traitements thermiques compris entre 750 et 900 °C et pour une durée comprise entre 1 et 8 heures.

Les corps semi-conducteurs ainsi traités selon le procédé de recuit thermique selon la présente invention sont particulièrement appropriés pour être ultérieurement traités sur des lignes de fabrication unipolaires, étant donné que les substrats de silicium destinés à recevoir des produits unipolaires (MOSFET) doivent présenter un grand nombre de petits amas.

**Revendications**

1. Procédé de traitement thermique préliminaire de corps semi-conducteurs contenant de l'oxygène en vue d'en accroître ultérieurement l'effet de piégeage interne, caractérisé en ce qu'il consiste à accroître le nombre des petits amas ou germes dans lesdits corps, par un recuit thermique effectué à une température comprise entre 750 et 950 °C et pendant une durée comprise entre 1 et 8 heures, lesdits petits amas ou germes étant destinés à servir de centres de nucléation ou de précipitation des atomes d'oxygène lors d'étapes thermiques ultérieures dans la fabrication de circuits intégrés à semi-conducteurs.

2. Procédé selon la revendication 1 caractérisé en ce qu'il consiste à pratiquer ledit recuit thermique desdits corps à une température comprise entre 750 et 900 °C pendant une durée comprise entre 2 et 8 heures.

3. Procédé selon la revendication 1 ou 2 caractérisé en ce que lesdits corps sont des barreaux tirés selon la méthode de Czochralski dans un four à résistance chauffante.

4. Procédé selon la revendication 1 ou 2 caractérisé en ce que lesdits corps sont des tranches semi-conductrices découpées à partir de barreaux tirés selon la méthode de Czochralski dans un four à résistance chauffante.

5. Procédé selon l'une quelconque des revendications ci-dessus, caractérisé en ce que le recuit thermique est effectué à 825 °C pendant 2 heures.

6. Procédé selon l'une quelconque des revendications ci-dessus, caractérisé en ce que les corps semi-conducteurs sont destinés à des lignes de fabrication de produits unipolaires.

**Claims**

1. Preliminary thermal-processing procedure for semiconductor bodies containing oxygen, designated to subsequently increase the internal trapping effect, characterized in that it consists of increasing the number of the small clusters in the said bodies, by a thermal annealing effected at a temperature between 750° and 950 °C, for a duration of from 1 to 8 hours, the said small clusters being destined to serve as centers of nucleation or precipitation of the oxygen atoms during the later thermal stages in the fabrication of semiconductor integrated circuits.

2. Procedure in accordance with claim 1, characterized in that it consists of practicing the said thermal annealing of the said bodies at a temperature between 750° and 900 °C, for a duration of from 2 to 8 hours.

3. Procedure in accordance with claim 1 or 2, characterized in that the said bodies are bars drawn in accordance with the Czochralski method in a heating-resistance oven.

4. Procedure in accordance with claim 1 or 2, characterized in that the said bodies are semiconductor slices cut from bars drawn in accordance with the Czochralski method in a heating-resistance oven.

5. Procedure in accordance with any of the above claims, characterized in that the thermal annealing is effected at 825 °C for a period of 2 hours.

6. Procedure in accordance with any of the above claims, characterized in that the semiconductor bodies are destined for unipolar device production lines.


**Ansprüche**

1. Verfahren zur thermischen Vorbehandlung von Halbleiterkörpern, die Sauerstoff enthalten, um später den internen Falleneffekt zu verstärken, dadurch gekennzeichnet, daß die Anzahl der kleinen Häufungen oder Keime in den genannten Körpern vermehrt wird, gekennzeichnet durch thermische Vergütung bei einer Temperatur von 750 bis 950 °C während einer Zeit von 1 bis 8 Stunden, wobei die genannten Häufungen oder Keime als Zentren für die Kernbildung oder Fällung von Sauerstoffatomen bei den späteren thermischen Stufen in der Herstellung integrierter Schaltungen mit Halbleitern dienen.

2. Verfahren gemäß Anspruch 1, dadurch gekennzeichnet, daß die genannte thermische Vergütung der genannten Körper in einer Temperatur von 750 bis 900 °C während einer Dauer von 2 bis 8 Stunden vorgenommen wird.

3. Verfahren gemäß Anspruch 1 oder 2, dadurch gekennzeichnet, daß die genannten Körper in einem Ofen mit Heizwiderstand nach der Methode von Czochralski gezogene Stäbe sind.

4. Verfahren gemäß Anspruch 1 oder 2, dadurch gekennzeichnet, daß die genannten Körper halbleitende Scheiben sind, die von nach der Methode von Czochralski in einem Ofen mit Heizwiderstand gezogenen Stäben abgeschnitten wurden.

5. Verfahren gemäß einem der vorangehenden Ansprüche, dadurch gekennzeichnet, daß die thermische Vergütung 2 Stunden lang bei einer Temperatur von 825 °C erfolgt.

6. Verfahren gemäß einem der vorangehenden Ansprüche, dadurch gekennzeichnet, daß die Halbleiterkörper für die Herstellungsanlagen unipolarer Erzeugnisse bestimmt sind.

FIG. 1

FIG. 2

FIG. 6

FIG. 7

FIG. 3

FIG. 4

FIG. 5